# EUROPÄISCHE PATENTSCHRIFT

(11) **EP 2 501 003 B1**
(45) Veröffentlichungstag und Bekanntmachung des Hinweises auf die Patenterteilung: **11.06.2014**
(21) Anmeldenummer: 12000749.7
(22) Anmeldetag: 04.02.2012
(51) Int. Cl.: H02G 3/08, H02B 1/26, H05K 7/14, H05K 5/00

(54) **Vier-Punkt-Keilverriegelungssystem eines aus Gehäuse-Unterteil und Gehäuse-Oberteil zusammengesetzten Gehäuses**
Four-point wedge locking system of a housing comprising a housing top section and housing bottom section
Système de verrouillage à quatre points d'un boîtier assemblé à partir d'une partie inférieure de boîtier et d'une partie supérieure de boîtier

(30) Priorität: 12.03.2011 DE 102011013782
(43) Veröffentlichungstag der Anmeldung: 19.09.2012
(73) Patentinhaber: ABB AG, 68309 Mannheim (DE)
(72) Erfinder: Albrecht, Sebastian, 96450 Coburg (DE); Ewers, Manfred, 58239 Schwerte (DE); Lange, Manfred, 44229 Dortmund (DE)

(56) Entgegenhaltungen:
- EP-A1- 1 215 949
- WO-A1-01/69992
- US-A- 6 010 351
- US-A1- 2005 007 747
- US-A1- 2008 239 692

## Beschreibung

Die Erfindung betrifft ein Vier-Punkt-Keilverriegelungssystem eines aus Gehäuse-Unterteil und Gehäuse-Oberteil zusammengesetzten Gehäuses. Beim Gehäuse kann es sich z. B. um ein Aufputzgehäuse eines Bewegungsmelders handeln.

Zweiteilige Gehäuse mit rechteckigem Querschnitt, welche aus einem Gehäuse-Unterteil und einem Gehäuse-Oberteil zusammengesetzt sind, werden üblicherweise abgedichtet, indem eine Dichtung zwischen den beiden Gehäuseteilen eingelegt und zumindest an allen vier Ecken je eine Verschraubung vorgesehen ist. Mittels dieser Verschraubungen werden die beiden Gehäuseteile unter Zwischenfügung der Dichtung zusammengepresst. Gegebenenfalls sind zusätzliche Zwischen-Verschraubungen zwischen diesen Eckverschraubungen vorgesehen, insbesondere bei relativ großen Gehäusen. Die Schraubenköpfe dieser Verschraubungen sind sichtbar oder müssen mittels Kappen abgedeckt werden, was in beiden Fällen zu einer inhomogenen frontseitigen Oberfläche führt, wodurch ein aus gestalterischer Sicht befriedigendes Ergebnis nicht erzielbar ist.

WO 01/69992 offenbart ein Vier-Punkt-Keilverriegelungssystem eines aus Gehäuse-Unterteil und Gehäuse-Oberteil zusammengesetzten Gehäuses mit rechteckförmigem Querschnitt, wobei im montierten Zustand die Seitenwände des Gehäuse-Unterteils über die Seitenwände des Gehäuse-Oberteils greifen. Das Gehäuse-Unterteil in seinem Innenraum nahe zweier sich gegenüberliegender Seitenwände zwei Aufnahmen aufweist, in welche im montierten Zustand je ein Seitenschenkel des Gehäuse-Oberteils eingreift.

Der Erfindung liegt die Aufgabe zugrunde, ein optimiertes Montagesystem eines aus Gehäuse-Unterteil und Gehäuse-Oberteil zusammengesetzten Gehäuses anzugeben.

Diese Aufgabe wird erfindungsgemäß gelöst durch ein Vier-Punkt-Keilverriegelungssystem eines aus Gehäuse-Unterteil und Gehäuse-Oberteil zusammengesetzten Gehäuses mit rechteckförmigem Querschnitt, wobei im montierten Zustand die Seitenwände des Gehäuse-Oberteils über die Seitenwände des Gehäuse-Unterteils greifen und eine Dichtung zwischen der Frontplatte des Gehäuse-Oberteils und den freien Stirnseiten der Seitenwände des Gehäuse-Unterteils vorgesehen ist,
- wobei das Gehäuse-Oberteil in seinem Innenraum nahe zweier sich gegenüberliegender Seitenwände zwei Aufnahmen aufweist, in welche im montierten Zustand je ein Seitenschenkel eines Keilschiebers eingreift,
- wobei sowohl jede der Aufnahmen als auch jeder Seitenschenkel jeweils mit mindestens zwei einander korrespondierenden Anpressflächen versehen sind,
- so dass eine in Richtung auf den Keilschieber ausgeübte Kraft über diese Anpressflächen in eine in Richtung auf die Rückseite des Gehäuse-Unterteils ausgeübte Kraft um 90° derart umgelenkt wird, dass das Gehäuse-Oberteil an seinen vier Eckbereichen gegen das Gehäuse-Unterteil unter Zusammenpressen der Dichtung gedrückt wird.

Die mit der Erfindung erzielbaren Vorteile liegen insbesondere darin, dass das vorgeschlagene Vier-Punkt-Keilverriegelungssystem ohne Schrauben im Sichtbereich des Gehäuses durch eine Keilwirkung in allen vier Eckbereichen des Gehäuses einen Anpressdruck auf die Dichtung derart erzeugt, dass am gesamten Gehäuseumfang eine gleichmäßige Stauchwirkung der Dichtung und damit eine Abdichtung des Gehäuses sichergestellt ist. Vorteilhaft ist die Oberfläche bzw. Frontseite des Gehäuses als homogene, nicht durch Schrauben gestörte Fläche realisierbar. Des Weiteren ergibt sich eine sehr zeitsparende Montage mit sehr wenigen Handgriffen, es ist lediglich der Keilschieber einzuführen.

In bevorzugter Weise ist der Keilschieber U-förmig ausgestaltet, mit einem Basisschenkel und den sich beiderseits anschließenden Seitenschenkeln.

Ein erhöhter Anpressdruck auf die Dichtung wird durch eine Verschraubung zwischen Keilschieber und Gehäuse über den Basisschenkel erzielt, d. h. die Verschraubung drückt den Basisschenkel zusätzlich in Richtung Gehäuse.

Zur Realisierung von Zusatzfunktionen des Keilschiebers ist es möglich, mindestens einen Seitenschenkel mit einem elektrischen Anschlusskabel zu versehen, welches vom Gehäuseinnenraum nach außen verläuft. Auf diese Weise kann beispielsweise Energie aus dem Gehäuseinnenraum nach außen geführt, werden, um eine mechanisch und elektrisch auf dem Keilschieber adaptierte Beleuchtung oder Kamera-Funktion zu ermöglichen. Umgekehrt kann auch mittels einer mechanisch und elektrisch auf dem Keilschieber adaptierten Solarzelle elektrische Energie erzeugt und in den Gehäuseinnenraum geführt werden.

Alternativ hierzu kann der Keilschieber auch in Form eines Lichtleiters ausgebildet sein, wodurch Licht aus dem Gehäuseinneren nach außen führbar ist.

Die Erfindung wird nachstehend an Hand der in der Zeichnung dargestellten Ausführungsbeispiele erläutert. Es zeigen:
- Fig. 1: eine perspektivische Ansicht der wichtigen Baukomponenten des Vier-Punkt-Keilverriegelungssystems,
- Fig. 2: eine perspektivische Ansicht eines Gehäuse-Unterteils,
- Fig. 3: eine perspektivische Ansicht eines Gehäuse-Oberteils,
- Fig. 4: einen Schnitt durch die Breitseite eines Gehäuses,
- Fig. 5: einen Schnitt durch die Schmalseite eines Gehäuses,
- Fig. 6: eine Prinzipskizze zur Erläuterung des Zusammenarbeitens der Anpressflächen von Gehäuse-Oberteil und Keilschieber,
- Fig. 7-11: unterschiedliche mögliche Ausführungsformen von Zusatzfunktionen eines Keilschiebers.

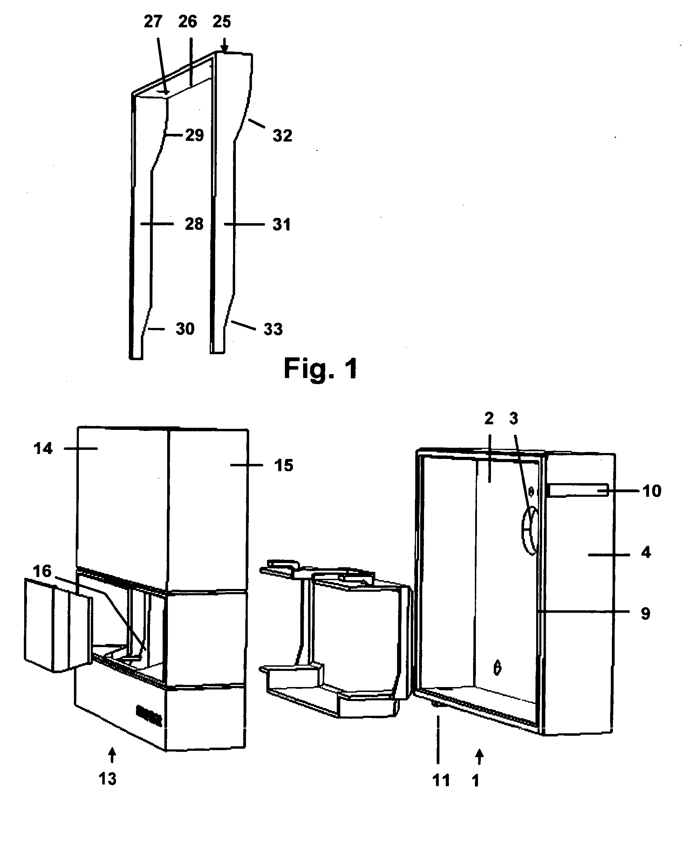

In Fig. 1 ist eine perspektivische Ansicht der wichtigen Baukomponenten des Vier-Punkt-Keilverriegelungssystems dargestellt. Es sind zu erkennen:
- ein Gehäuse-Unterteil 1 eines Gehäuses, welches eine Rückseite 2 mit mindestens einer Einführöffnung 3 für Kabel aufweist, wobei umlaufend vier Seitenwände 4 mit ihren ersten Stirnseiten rechtwinklig auf diese Rückseite 2 aufsetzen (indem sie vorzugsweise einstückig an die Rückseite 2 angeformt sind) und wobei eine Dichtung 9 aus einem elastischen Material an den freien Stirnseiten der Seitenwände 4 vorgesehen ist,
- ein Gehäuse-Oberteil 13 eines Gehäuses, welches eine Frontseite 14 aufweist, an welche sich vier umlaufend angeordnete Seitenwände 15 anschließen (indem sie vorzugsweise einstückig an die Frontseite 14 angeformt sind),
- ein Keilschieber 25, welcher vorzugsweise U-förmig ausgebildet ist und einen Basisschenkel 26 mit zwei sich hieran rechtwinklig erstreckenden Seitenschenkeln 28, 31 aufweist, wobei der erste Seitenschenkel 28 eine erste Anpressfläche 29 sowie eine zweite Anpressfläche 30 aufweist und der zweite Seitenschenkel 31 eine dritte Anpressfläche 32 sowie eine vierte Anpressfläche 33 aufweist. Im Basisschenkel 26 sind für Verschraubungszwecke dienende Öffnungen 27 eingebracht.

Das Gehäuse ist zur Wandmontage geeignet - z. B. als Aufputzgehäuse eines Bewegungsmelders - und weist entsprechende Vorrichtungen hierzu auf, z. B. Bohrungen in den Ecken der Rückwand 2, durch welche Schrauben greifen, die in einer Wand zu verankern sind (z. B. unter Verwendung von Dübeln). Im montierten Zustand des Gehäuses greifen die Seitenwände 15 des Gehäuse-Oberteils 13 über die Seitenwände 4 des Gehäuse-Unterteils 1. Das Gehäuse-Unterteil 1 ist z. B. mit zwei Führungsleisten 10, 11 an zwei unterschiedlichen Seitenwänden 4 versehen, um derart das Ineinanderschieben von Gehäuse-Unterteil 1 und Gehäuse-Oberteil 13 zu erleichtern und um insbesondere ein Verkanten während dieses Ineinanderschiebens zu verhindern.

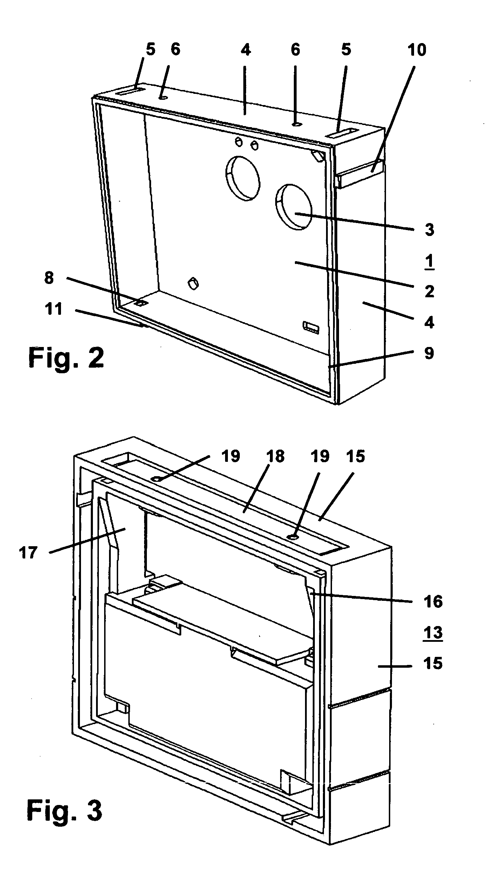

In Fig. 2 ist eine perspektivische Ansicht eines Gehäuse-Unterteils dargestellt. Insbesondere sind zu erkennen:
- die Rückwand 2 des Gehäuse-Unterteils 1 mit mehreren eingebrachten Einführöffnungen 3 für Kabel,
- die Seitenwände 4, wobei eine Seitenwand 5 mit zwei Einführschlitzen 5 für die Seitenschenkel 28, 31 des Keilschiebers 25 sowie mit zwei für Verschraubungszwecke dienenden Öffnungen 6 versehen sind und wobei die dieser Seitenwand 5 gegenüberliegende Seitenwand mit Aufnahmeöffnungen 8 versehen ist, deren Abmessungen derart gestaltet sind, dass die Enden der Seitenschenkel 28, 31 arretierend eingreifen können.

Ferner sind die Führungsleisten 10, 11 skizziert.

In Fig. 3 ist eine perspektivische Ansicht eines Gehäuse-Oberteils dargestellt. Insbesondere sind zu erkennen:
- eine erste innerhalb des Gehäuseinnenraumes längs einer Seitenwand 15 angeordnete Aufnahme 16, welche zur Aufnahme des ersten Seitenschenkels 28 des Keilschiebers 25 dient und einen Einführschlitz an einer Seitenwand 15 des Gehäuse-Oberteils 13 aufweist,
- eine zweite innerhalb des Gehäuseinnenraumes längs einer Seitenwand 15 angeordnete Aufnahme 17, welche zur Aufnahme des zweiten Seitenschenkels 31 des Keilschiebers 25 dient und einen Einführschlitz an einer Seitenwand 15 des Gehäuse-Oberteils 13 aufweist,
- eine an einer Seitenwand 15 vorgesehene Aufnahme 18, welche zur Aufnahme des Basisschenkels 26 des Keilschiebers 25 dient,
- zwei in diese Aufnahme 18 eingebrachte, für Verschraubungszwecke dienende Bohrungen 19.

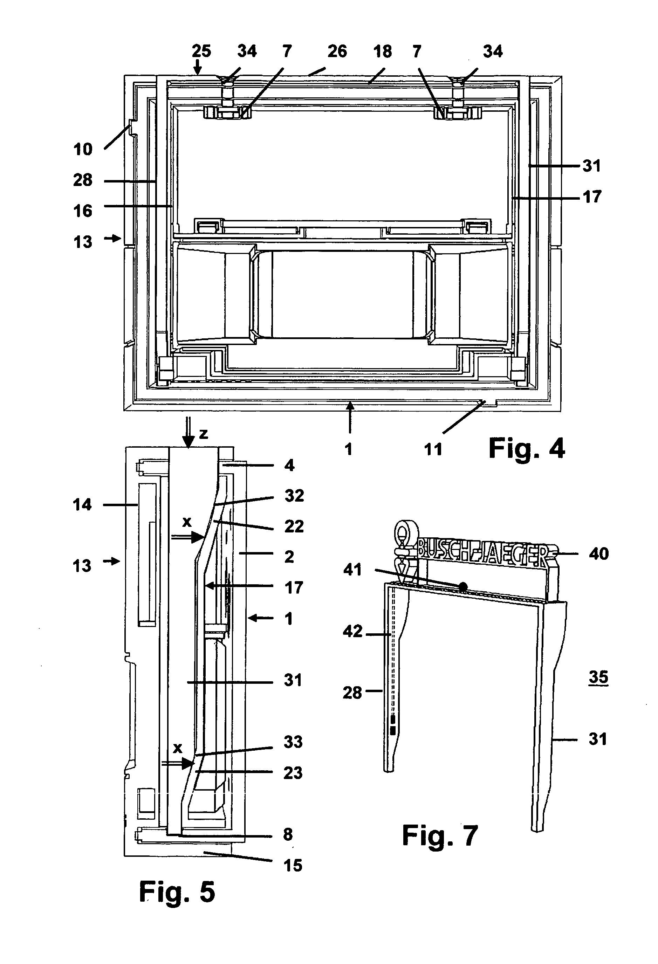

In Fig. 4 ist ein Schnitt durch die Breitseite eines Gehäuses dargestellt. Es sind die beiden ineinandergeschobenen Gehäuse-Baukomponenten Gehäuse-Unterteil 1 und Gehäuse-Oberteil 13 zu erkennen, wobei der Eingriff der Führungsleisten 10, 11 des Gehäuse-Unterteils 1 in entsprechenden Nuten des Gehäuse-Oberteils 13 gezeigt ist. Insbesondere ist die Verankerung des Keilschiebers 25 innerhalb des Gehäuses zu erkennen:
- der erste Seitenschenkel 28 des Keilschiebers 25 greift in die erste Aufnahme 16 des Gehäuse-Oberteils 13,
- der zweite Seitenschenkel 31 des Keilschiebers 25 greift in die zweite Aufnahme 17 des Gehäuse-Oberteils 13,
- der Basisschenkel 26 des Keilschiebers 25 taucht bündig in die Aufnahme 18 des Gehäuse-Oberteils 13 ein,
- Schrauben 34 greifen durch die Öffnungen 27 im Basisschenkel 26, die Bohrungen 19 des Gehäuse-Oberteils 13 und die Öffnungen 6 des Gehäuse-Unterteils 1 und werden mit Muttern 7 verschraubt, welche im Gehäuseinnenraum des Gehäuse-Unterteils 1 angeordnet sind.

Durch die Verschraubung mittels Schrauben 34 / Muttern 7 ergibt sich eine lösbare Arretierung der beiden ineinandergreifenden Gehäuseteile 1, 13 mit hohem, auf die Dichtung 9 wirkendem Anpressdruck.

In Fig. 5 ist ein Schnitt durch die Schmalseite eines Gehäuses dargestellt. Es sind wiederum die beiden ineinandergeschobenen Gehäuse-Baukomponenten Gehäuse-Unterteil 1 mit Rückwand 2 sowie Seitenwänden 4 und Gehäuse-Oberteil 13 mit Frontplatte 14 und Seitenwänden 15 zu erkennen. Insbesondere ist wiederum die Verankerung des Keilschiebers 25 innerhalb des Gehäuses gezeigt. Der zweite Seitenschenkel 31 des Keilschiebers 25 greift in die zweite Aufnahme 17 des Gehäuse-Oberteils 13 ein:
- dabei drückt die dritte Anpressfläche 32 des Keilschiebers 25 gegen die dritte Anpressfläche 22 der zweiten Aufnahme 17,
- dabei drückt die vierte Anpressfläche 33 des Keilschiebers 25 gegen die vierte Anpressfläche 23 der zweiten Aufnahme 17,
- dabei greift das Ende des zweiten Seitenschenkels 31 arretierend in eine Aufnahmeöffnung 8 in einer Seitenwand 15 des Gehäuse-Oberteils 13.

Eine in Richtung z auf den Keilschieber 25 ausgeübte Kraft wird hierdurch in eine in Richtung x auf die Rückseite 2 des Gehäuse-Unterteils ausgeübte Kraft um 90° umgelenkt, wodurch das Gehäuse-Oberteil 13 gegen das Gehäuse-Unterteil 1 gedrückt wird - unter Zusammenpressen der Dichtung 9 mit hohem Anpressdruck.

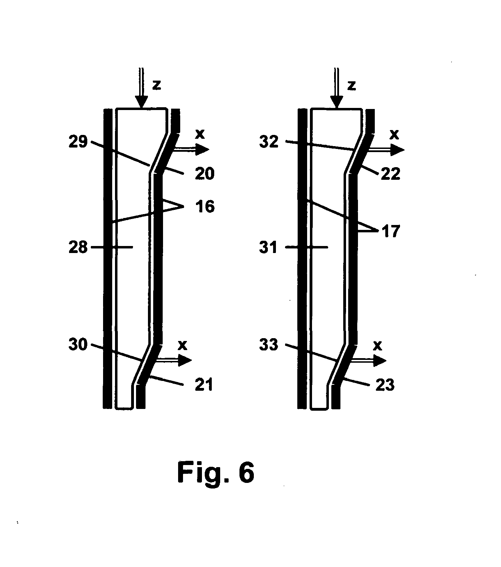

In Fig. 6 ist in Ergänzung zur Fig. 5 eine Prinzipskizze zur Erläuterung des Zusammenwirkens der Anpressflächen von Gehäuse-Oberteil und Keilschieber dargestellt:
- die erste Anpressfläche 29 des ersten Seitenschenkels 28 des Keilschiebers 25 drückt gegen die erste Anpressfläche 20 der ersten Aufnahme 16 des Gehäuse-Oberteils 13,
- die zweite Anpressfläche 30 des ersten Seitenschenkels 28 des Keilschiebers 25 drückt gegen die zweite Anpressfläche 21 der ersten Aufnahme 16 des Gehäuse-Oberteils 13,
- die dritte Anpressfläche 32 des zweiten Seitenschenkels 31 des Keilschiebers 25 drückt gegen die dritte Anpressfläche 22 der zweiten Aufnahme 17 des Gehäuse-Oberteils 13,
- die vierte Anpressfläche 33 des zweiten Seitenschenkels 31 des Keilschiebers 25 drückt gegen die vierte Anpressfläche 23 der zweiten Aufnahme 17 des Gehäuse-Oberteils 13.

Durch diese Konfiguration ergibt sich eine Umlenkung der in Richtung z auf den Keilschieber 25 ausgeübten Kraft in eine in Richtung x zur Rückseite 2 des Gehäuse-Unterteils 1 ausgeübte Kraft um 90° an den vier durch die Anpressflächen 29/20, 30/21, 31/22, 33/23 definierten Flächen, wodurch das Gehäuse-Oberteil 13 an vier definierten Flächen - den Gehäuseecken - gegen das Gehäuse-Unterteil 1 gedrückt wird - unter Zusammenpressen der Dichtung 9. Wie vorstehend bereits erwähnt, ergibt sich eine Erhöhung des Anpressdrucks für die Dichtung 9 durch Anziehen der vorgesehenen Schrauben 34.

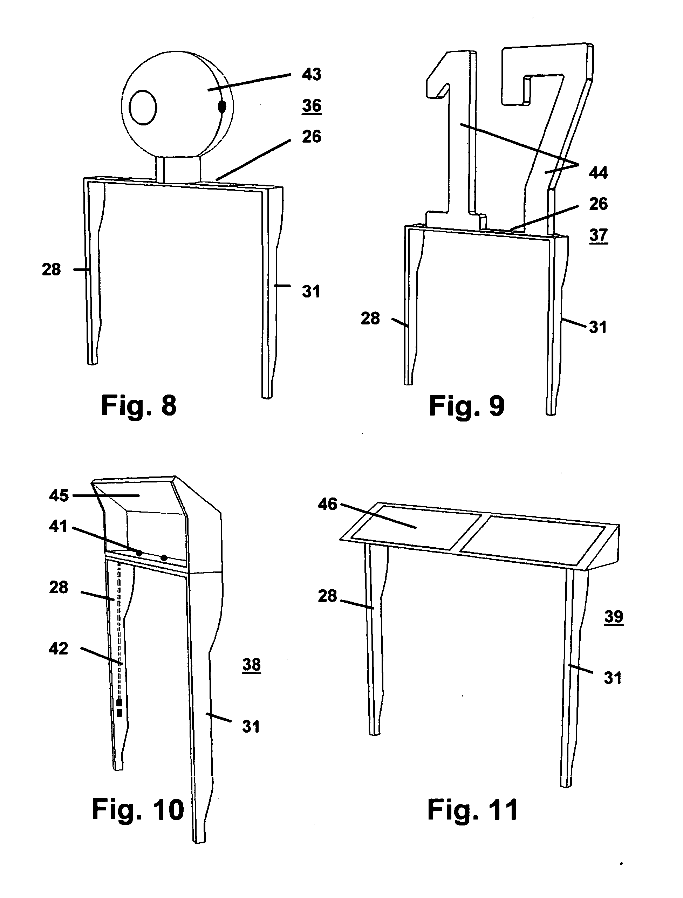

In den Fig. 7 - 11 sind unterschiedliche mögliche Ausführungsformen von Zusatzfunktionen eines Keilschiebers dargestellt, wobei jeweils ein Keilschieber mit den beiden Seitenschenkeln 28, 31 als Basis dient:
- Gemäß Fig. 7 ist der Keilschieber 25 in Form eines Keilschiebers 35 mit einer Beschriftung 40, z. B. einem Firmenlogo, ausgebildet. Dabei kann die am Basisschenkel 26 angeordnete Beschriftung mittels einer LED 41 (oder mittels mehrerer LEDs) beleuchtet werden, wobei die Energieversorgung der LED 41 über Anschlusskabel 42 erfolgt, welche längs eines Seitenschenkels (oder beider Seitenschenkel) des Keilschiebers verlaufen und welche endseitige Kontaktierungen aufweisen.
- Gemäß Fig. 8 ist der Keilschieber 25 in Form eines Keilschiebers 36 mit einer mit dem Basisschenkel 26 verbundenen Kamera / Webcam 43 ausgebildet.
- Gemäß Fig. 9 ist der Keilschieber 25 in Form eines Keilschiebers 37 mit einer mit dem Basisschenkel 26 verbundenen Hausnummer 44 ausgebildet.
- Gemäß Fig. 10 ist der Keilschieber 25 in Form eines Keilschiebers 38 mit Lichtmodul / Reflektorleuchte ausgebildet. Die Beleuchtung erfolgt über am Basisschenkel 26 befestigte LEDs 41, deren Energieversorgung über Anschlusskabel 42 erfolgt, welche längs eines Seitenschenkels (oder beider Seitenschenkel) des Keilschiebers verlaufen und welche endseitige Kontaktierungen aufweisen. Zur gezielten Abstrahlung des Lichts ist ein Reflektor 45 am Basisschenkel 26 befestigt.
- Gemäß Fig. 11 ist der Keilschieber 25 in Form eines Keilschiebers 39 mit einer Solarzelle 46 ausgebildet, wobei sich die Solarzelle 46 über den Basisschenkel 26 erstreckt.

Auch wenn vorstehend stets von einem U-förmigen Keilschieber ausgegangen wird, ist es in Abwandlung möglich, den Keilschieber lediglich aus den beiden Seitenschenkeln unter Fortfall des Basisschenkels zu bilden, was zu einer Konstruktionsvariante mit einem zweigeteilten Keilschieber führt.

Wie es aus den vorstehenden Ausführungen bereits hervorgeht, können zur Realisierung von Zusatzfunktionen beide Seitenschenkel (oder ein Seitenschenkel) mit elektrisch leitenden Kontakten Spannung/Leistung im Gehäuse abnehmen und zu einer außerhalb des Gehäuses liegenden Schnittstelle führen, wobei beispielsweise an dieser Schnittstelle
- ein Lichtmodul oder eine Reflektorleuchte zur Wegebeleuchtung mechanisch und elektrisch auf dem Keilschieber adaptiert sind,
- eine beleuchtete Hausnummer 44 mechanisch und elektrisch auf dem Keilschieber adaptiert ist,
- eine Solarzelle 46 mechanisch und elektrisch auf dem Keilschieber adaptiert ist, um derart das mit dem Gehäuse verknüpfte elektrische Gerät, z. B. einen Bewegungsmelder, mit Energie zu versorgen,
- eine Kamera / Webcam 43 mechanisch und elektrisch auf dem Keilschieber adaptiert ist.

In Abwandlung dieser Ausführungsformen ist es auch möglich, den Keilschieber in Form eines Lichtleiters auszubilden und eine Lichtquelle innerhalb des Gehäuses vorzusehen, wodurch es ermöglicht wird, Licht in gezielter Art und Weise aus dem Gehäuseinneren nach außen zu führen, um derart z. B.
- einen Lichtkranz um das Gehäuse zu bilden,
- um an einer definierten Stelle einen Lichtaustritt zuzulassen, der dann z. B. über einen Reflektor zur Wegebeleuchtung dient.

Selbstverständlich ist es in weiterer Abwandlung auch möglich, ein Firmenlogo, einen Schriftzug oder eine Hausnummer unbeleuchtet und rein mechanisch auf dem Keilschieber zu adaptieren.

Vorstehend wird davon ausgegangen, dass die Dichtung 9 an den freien Stirnseiten der Seitenwände 4 des Gehäuse-Unterteils 1 angebracht ist. Im montierten Zustand drückt diese Dichtung 9 dann gegen die Frontplatte 14 des Gehäuse-Oberteils 13. In Abwandlung hiervon ist es selbstverständlich auch möglich, die Dichtung 9 an der Frontplatte 14 im Innenraum des Gehäuse-Oberteils 13 anzubringen. Im montierten Zustand drücken dann die freien Stirnseiten der Seitenwände 4 des Gehäuse-Unterteils 1 gegen die Dichtung 9.

### Bezugszeichenliste

- 1: Gehäuse-Unterteil
- 2: Rückseite
- 3: Einführöffnung für Kabel
- 4: Seitenwände
- 5: Einführschlitze für Keilschieber
- 6: Öffnungen für Schrauben
- 7: Muttern
- 8: Aufnahmeöffnungen für Keilschieber
- 9: Dichtung an den freien Stirnseiten der Seitenwände
- 10: Führungsleiste
- 11: Führungsleiste
- 12: -
- 13: Gehäuse-Oberteil
- 14: Frontplatte
- 15: Seitenwände
- 16: erste Aufnahme
- 17: zweite Aufnahme
- 18: Aufnahme für Basisschenkel
- 19: Bohrungen für Schrauben
- 20: erste Anpressfläche
- 21: zweite Anpressfläche
- 22: dritte Anpressfläche
- 23: vierte Anpressfläche
- 24: -
- 25: Keilschieber
- 26: Basisschenkel
- 27: Öffnungen für Schrauben
- 28: erster Seitenschenkel
- 29: erste Anpressfläche
- 30: zweite Anpressfläche
- 31: zweiter Seitenschenkel
- 32: dritte Anpressfläche
- 33: vierte Anpressfläche
- 34: Schrauben
- 35: Keilschieber mit Beschriftung, z. B. Firmenlogo
- 36: Keilschieber mit Kamera / Webcam
- 37: Keilschieber mit Hausnummer
- 38: Keilschieber mit Lichtmodul / Reflektorleuchte
- 39: Keilschieber mit Solarzelle
- 40: Beschriftung
- 41: LED
- 42: Anschlusskabel
- 43: Kamera / Webcam
- 44: Hausnummer
- 45: Reflektor
- 46: Solarzelle

- z: Richtung der auf den Keilschieber ausgeübten Kraft
- x: Richtung der um 90° umgelenkten, auf das Gehäuse-Unterteil ausgeübten Kraft

## Patentansprüche

1. Vier-Punkt-Keilverriegelungssystem eines aus Gehäuse-Unterteil (1) und Gehäuse-Oberteil (13) zusammengesetzten Gehäuses mit rechteckförmigem Querschnitt, wobei im montierten Zustand die Seitenwände (15) des Gehäuse-Oberteils (13) über die Seitenwände (4) des Gehäuse-Unterteils (1) greifen und eine Dichtung (9) zwischen der Frontplatte (14) des Gehäuse-Oberteils (13) und den freien Stirnseiten der Seitenwände (4) des Gehäuse-Unterteils (1) vorgesehen ist,
• wobei das Gehäuse-Oberteil (13) in seinem Innenraum nahe zweier sich gegenüberliegender Seitenwände (15) zwei Aufnahmen (16, 17) aufweist, in welche im montierten Zustand je ein Seitenschenkel (28, 31) eines Keilschiebers (25) eingreift,
• wobei sowohl jede der Aufnahmen (16, 17) als auch jeder Seitenschenkel (28, 31) jeweils mit mindestens zwei einander korrespondierenden Anpressflächen (20, 21, 22, 23, 29, 30, 32, 33) versehen sind,
• so dass eine in Richtung (z) auf den Keilschieber (25) ausgeübte Kraft über diese Anpressflächen (20, 21, 22, 23, 29, 30, 32, 33) in eine in Richtung auf die Rückseite (2) des Gehäuse-Unterteils (1) ausgeübte Kraft um 90° derart umgelenkt wird, dass das Gehäuse-Oberteil (13) an seinen vier Eckbereichen gegen das Gehäuse-Unterteil (1) unter Zusammenpressen der Dichtung (9) gedrückt wird.

2. Vier-Punkt-Keilverriegelungssystem nach Anspruch 1, **gekennzeichnet durch** eine U-förmige Ausgestaltung des Keilschiebers (25) mit einem Basisschenkel (26) und den sich beiderseits anschließenden Seitenschenkel (28, 31).

3. Vier-Punkt-Keilverriegelungssystem nach Anspruch 2, **gekennzeichnet durch** eine Verschraubung zwischen Keilschieber (25) und Gehäuse (1, 2) über den Basisschenkel (26).

4. Vier-Punkt-Keilverriegelungssystem nach einem der vorstehenden Ansprüche, **dadurch gekennzeichnet, dass** mindestens ein Seitenschenkel (28, 31) mit einem elektrischen Anschlusskabel (42) versehen ist, welches vom Gehäuseinnenraum nach außen verläuft.

5. Vier-Punkt-Keilverriegelungssystem nach einem der vorstehenden Ansprüche, **dadurch gekennzeichnet, dass** der Keilschieber (25) in Form eines Lichtleiters ausgebildet ist, wodurch Licht aus dem Gehäuseinneren nach außen führbar ist.

6. Vier-Punkt-Keilverriegelungssystem nach einem der vorstehenden Ansprüche, **dadurch gekennzeichnet, dass** der Keilschieber mit einer Beschriftung (40) oder Bezifferung (44) versehen ist.

7. Vier-Punkt-Keilverriegelungssystem nach einem der vorstehenden Ansprüche, **dadurch gekennzeichnet, dass** der Keilschieber zusätzlich mit einer Kamera (43) versehen ist.

8. Vier-Punkt-Keilverriegelungssystem nach einem der vorstehenden Ansprüche, **dadurch gekennzeichnet, dass** der Keilschieber zusätzlich mit einem Lichtmodul (41, 45) versehen ist.

9. Vier-Punkt-Keilverriegelungssystem nach einem der vorstehenden Ansprüche, **dadurch gekennzeichnet, dass** der Keilschieber zusätzlich mit einer Solarzelle (46) versehen ist.

## Claims

1. Four-point wedge locking system of a housing which is made up of a housing lower part (1) and a housing upper part (13) and has a rectangular cross section, wherein, in the assembled state, the side walls (15) of the housing upper part (13) extend over the side walls (4) of the housing lower part (1) and a seal (9) is provided between the front panel (14) of the housing upper part (13) and the free end sides of the side walls (4) of the housing lower part (1),
• wherein the housing upper part (13) has two receptacles (16, 17) close to two opposite side walls (15) in its interior, a respective side limb (28, 31) of a wedge slide (25) engaging in the said receptacles in the assembled state,
• wherein both each of the receptacles (16, 17) and also each of the side limbs (28, 31) are in each case provided with at least two contact surfaces (20, 21, 22, 23, 29, 30, 32, 33) which correspond to one another,
• so that a force which is exerted on the wedge slide (25) in direction (z) is deflected through 90° by means of the said contact surfaces (20, 21, 22, 23, 29, 30, 32, 33) into a force which is exerted in the direction of the rear side (2) of the housing lower part (1) in such a way that the housing upper part (13) is pushed against the housing lower part (1) at its four corner regions so as to compress the seal (9).

2. Four-point wedge locking system according to Claim 1, **characterized by** a U-shaped design of the wedge slide (25) with a base limb (26) and the side limbs (28, 31) which adjoin the said base limb on either side.

3. Four-point wedge locking system according to Claim 2, **characterized by** a screw arrangement between the wedge slide (25) and the housing (1, 2) by means of the base limb (26).

4. Four-point wedge locking system according to one of the preceding claims, **characterized in that** at least one side limb (28, 31) is provided with an electrical connection cable (42) which runs from the housing interior to the outside.

5. Four-point wedge locking system according to one of the preceding claims, **characterized in that** the wedge slide (25) is designed in the form of a light guide, as a result of which light can be routed from the housing interior to the outside.

6. Four-point wedge locking system according to one of the preceding claims, **characterized in that** the wedge slide is provided with lettering (40) or numbering (44).

7. Four-point wedge locking system according to one of the preceding claims, **characterized in that** the wedge slide is additionally provided with a camera (43).

8. Four-point wedge locking system according to one of the preceding claims, **characterized in that** the wedge slide is additionally provided with a light module (41, 45).

9. Four-point wedge locking system according to one of the preceding claims, **characterized in that** the wedge slide is additionally provided with a solar cell (46).

## Revendications

1. Système de verrouillage à clavette à quatre points d'un boîtier assemblé à partir d'une partie inférieure de boîtier (1) et d'une partie supérieure de boîtier (13), de section transversale rectangulaire, les parois latérales (15) de la partie supérieure de boîtier (13), dans l'état monté, venant en prise par-dessus les parois latérales (4) de la partie inférieure de boîtier (1) et un joint d'étanchéité (9) étant prévu entre la plaque frontale (14) de la partie supérieure de boîtier (13) et les côtés frontaux des parois latérales (4) de la partie inférieure de boîtier (1),
- la partie supérieure de boîtier (13) présentant deux logements (16, 17) dans son espace interne à proximité de deux parois latérales (15) opposées, dans lesquels logements, dans l'état monté, s'engage à chaque fois une branche latérale (28, 31) d'une vanne à tiroir (25),
- chacun des logements (16, 17) ainsi que chacune des branches latérales (28, 31) étant à chaque fois pourvu d'au moins deux faces de pressage se correspondant mutuellement (20, 21, 22, 23, 29, 30, 32, 33),
- de telle sorte qu'une force exercée dans la direction (z) sur la vanne à tiroir (25) soit déviée de 90° par le biais de ces faces de pressage (20, 21, 22, 23, 29, 30, 32, 33) en une force exercée dans la direction du côté arrière (2) de la partie inférieure de boîtier (1), de telle sorte que la partie supérieure de boîtier (13) soit pressée au niveau de ses quatre régions de coin contre la partie inférieure de boîtier (1) avec compression du joint d'étanchéité (9).

2. Système de verrouillage à clavette à quatre points selon la revendication 1, **caractérisé par** une configuration en forme de U de la vanne à tiroir (25) avec une branche de base (26) et les branches latérales (28, 31) s'y raccordant de chaque côté.

3. Système de verrouillage à clavette à quatre points selon la revendication 2, **caractérisé par** un vissage entre la vanne à tiroir (25) et le boîtier (1, 2) par le biais de la branche de base (26).

4. Système de verrouillage à clavette à quatre points selon l'une quelconque des revendications précédentes, **caractérisé en ce qu'**au moins une branche latérale (28, 31) est munie d'un câble de raccordement électrique (42) qui s'étend depuis l'espace interne du boîtier vers l'extérieur.

5. Système de verrouillage à clavette à quatre points selon l'une quelconque des revendications précédentes, **caractérisé en ce que** la vanne à tiroir (25) est réalisée sous la forme d'un guide de lumière de sorte que de la lumière puisse être guidée vers l'extérieur depuis l'intérieur du boîtier.

6. Système de verrouillage à clavette à quatre points selon l'une quelconque des revendications précédentes, **caractérisé en ce que** la vanne à tiroir est pourvue d'une inscription (40) ou d'une numérotation (44).

7. Système de verrouillage à clavette à quatre points selon l'une quelconque des revendications précédentes, **caractérisé en ce que** la vanne à tiroir est en outre pourvue d'une caméra (43).

8. Système de verrouillage à clavette à quatre points selon l'une quelconque des revendications précédentes, **caractérisé en ce que** la vanne à tiroir est en outre pourvue d'un module d'éclairage (41, 45).

9. Système de verrouillage à clavette à quatre points selon l'une quelconque des revendications précédentes, **caractérisé en ce que** la vanne à tiroir est en outre pourvue d'une pile solaire (46).
